# EUROPÄISCHE PATENTSCHRIFT

(11) **EP 1 673 800 B1**
(45) Veröffentlichungstag und Bekanntmachung des Hinweises auf die Patenterteilung: **21.03.2007**
(21) Anmeldenummer: 04789914.1
(22) Anmeldetag: 01.10.2004
(51) Int. Cl.: H01L 21/00

(54) **Verfahren zur Herstellung und Vorrichtung zur Verbesserung der Haftung zwischen einem Kunststoff und einem Metall**
Production method and device for improving the bonding between plastic and metal
Procédé de réalisation et dispositif d'amélioration de l'adhésion entre une matière plastique et un métal

(30) Priorität: 16.10.2003 DE 10348715
(43) Veröffentlichungstag der Anmeldung: 28.06.2006
(73) Patentinhaber: Infineon Technologies AG, 81669 München (DE)
(72) Erfinder: BETZ, Bernd, 93073 Neutraubling (DE); DANGELMAIER, Jochen, 93176 Beratzhausen (DE); PAULUS, Stefan, 93197 Zeitlarn (DE)
(74) Vertreter: Schäfer, Horst
(86) Internationale Anmeldenummer: PCT/DE2004/002199
(87) Internationale Veröffentlichungsnummer: WO 2005/041272

(56) Entgegenhaltungen:
- EP-A- 0 533 137
- EP-A- 1 191 590
- US-A- 5 554 569

## Beschreibung

Die Erfindung betrifft ein Leadframe, bzw. einen Flachleiterrahmen bzw. dessen Grundkörper, für ein Halbleiterbauteil.

Ein solcher Flachleiterrahmen ist aus der US-A-5,554,569 bekannt. In diesem Dokument wird ein Verfahren zur mechanischen Aufrauhung der Oberfläche eines Flachleiterrahmens durch Beschuß mit abrasiven, mikroskopisch kleinen Teilchen beschrieben, die u.a. Sand, Siliziumdioxid oder Aluminiumdioxid aufweisen.

Der Flachleiterrahmen gemäß der US-A-5,554,569 läßt sich kaum wirtschaftlich herstellen, denn es muß ein trockener Prozeß durchgeführt werden zusätzlich zu den naßchemischen Prozessen zur Reinigung und Veredelung der Flachleiteroberfläche in einer geschlossenen Produktionslinie mit räumlich nacheinander angeordneten Bädern. Außerdem muß ein Reinigungsschritt zur Entfernung der Strahlmittelreste von der Flachleiteroberfläche vorgesehen werden.

Die US-A-5,554,569 berichtet daneben von Haftungsvermittlern zur Verbesserung der Haftung zwischen Flachleiter und Kunststoffverkapselung. Außerdem sei bekannt, daß die Haftung zwischen Flachleiter und Kunststoff dadurch verbessert werden kann, daß gezielt Kupferoxide auf den Flachleiterrahmen aufgebracht werden. Die genannten Verfahren haben jedoch alle den Nachteil, schwierig in ihrer Durchführung zu sein.

Die EP 0 533 137 A2 zeigt einen Flachleiterrahmen, der aus zwei Schichten besteht. Die dem Chip abgewandte Schicht wurde mit Öffnungen versehen. Bei einem folgenden Ätzvorgang entstehen in der dem Chip zugewandten Schicht Hohlräume, deren Durchmesser größer als der Durchmesser der Öffnungen ist; um dies zu erreichen, hat die dem Chip abgewandte Schicht ein Material geringerer Ätzrate als die andere Schicht. Die Flachleiterrahmen müssen also speziell hergestellt werden; herkömmliche Flachleiterrahmen sind nicht brauchbar.

Bei allen mit den nach Stand der Technik bekannten Verfahren hergestellten Halbleiterbauteilen treten außerdem trotzdem Schäden und Unzuverlässigkeiten im Betrieb auf.

Aufgabe der vorliegenden Erfindung ist es daher, ein Halbleiterbauteil bereitzustellen, das sich stets zuverlässig betreiben läßt.

Diese Aufgabe wird durch den Gegenstand der unabhängigen Patentansprüche gelöst. Vorteilhafte Weiterbildungen ergeben sich aus den jeweiligen abhängigen Patentansprüchen.

Die Erfindung stellt ein Leadframe bzw. einen Flachleiterrahmen bzw. dessen Grundkörper mit einer aufgerauhten, dreidimensionalen Oberfläche bereit, welche eine weit verbesserte Haftung für den umschließenden Kunststoff im Halbleiterbauteil bietet. Das erfindungsgemäße Herstellverfahren läßt sich einfach und wirtschaftlich in die existierende Fertigungskette zur Reinigung und Veredelung des Flachleiterrahmens integrieren.

Der Flachleiterrahmen wird nach dem Stanzen verschiedenen naßchemischen und/oder galvanischen Prozessen, wie Entfetten, Beizen, und/oder dem Aufbringen verschiedener Schichten unterworfen.

Im Anschluß an diese herkömmlichen Fertigungsschritte wird erfindungsgemäß in einem ersten Schritt eine weitere Zwischenschicht auf naßchemischem Weg aufgebracht, die Nickel und/oder Silber und/oder eine silberhaltige Legierung oder Verbindung aufweist. In einem zweiten Schritt wird, wiederum auf naßchemischem Weg, die Oberfläche der aufgebrachten Zwischenschicht so angeätzt, daß diese eine dreidimensionale Oberflächenstruktur erhält. In einem letzten Schritt wird der Flachleiterrahmen gereinigt, um alle Verunreinigungen, die sich auf der Oberfläche angesammelt haben, zu entfernen.

Der Vorteil dieses Verfahrens zur Herstellung des erfindungsgemäßen Flachleiters mit verbesserter Haftung liegt darin, daß es aufgrund der Art der involvierten Prozesse ohne großen Aufwand möglich ist, die benötigten Fertigungsschritte in eine bereits vorhandene Fertigungslinie zur Reinigung und Veredelung von Flachleiterrahmen einzufügen. Das Aufbringen und Anätzen der erfindungsgemäßen Zwischenschicht wird in separaten Bädern geschehen, während für den abschließende Reinigungsschritt auf bereits vorhandene Becken zurückgegriffen werden kann.

Für Flachleiterrahmen, die in Form von Endlosbändern hergestellt und prozessiert werden, ergibt sich als weiterer Vorteil im Vergleich zum Stand der Technik, daß zusätzliche Bäder einfach in die auf die Endlosform abgestimmte Fertigungsstraße integriert werden können. Das Einfügen einer Kammer für den Strahlprozeß in eine Endloslinie hingegen birgt, vor allem wegen der benötigten Dichtigkeit am Kammereingang sowie am Kammerausgang, große technische Problem in sich.

Der Vorteil des erfindungsgemäßen Flachleiters besteht im Vergleich zu Flachleitern, deren Oberfläche mit Haftvermittlern behandelt wurde, in den weitaus niedrigeren Herstellungskosten.

Der Vorteil im Vergleich zu einem Flachleiter, dessen Oberfläche mittels Strahlen behandelt wurde, liegt, neben den niedrigeren Kosten wegen der einfacheren Herstellbarkeit, auch darin, daß der erfindungsgemäße Flachleiter entsprechend der Güte des abschließenden Reinigungsschrittes frei von störenden Partikeln ist, die Ursache für den Ausfall eines Bauteils sein können.

Wie bereits erwähnt, ist ein besonders wirtschaftlicher Weg zur Aufbringung des für die Zwischenschicht benötigten Silbers das Abscheiden aus einem wäßrigen Bad mittels herkömmlicher chemischer oder galvanischer Abscheidverfahren, weil diese auf einfache Weise in die bereits existierende Fertigungskette zur Reinigung und Veredelung des Flachleiterrahmens integriert werden können.

Das gleiche gilt für Zwischenschichten, die eine Silberlegierung und/oder Silberverbindung und/oder Nickel aufweisen. Auch hier sind naßchemische Abscheidprozesse vorteilhaft.

Die Zwischenschicht kann dabei als eine Lage, die nur dem Zweck der Herstellung einer dreidimensionalen Oberflächenstruktur dient, aufgebracht werden.

Es ist aber möglich und denkbar, statt einer homogenen Zwischenschicht eine Schicht, die mehrere Lagen aufweist, aufzubringen. Dies ist vor allem dann wünschenswert, wenn die Zwischenschicht neben dem Bereitstellen der dreidimensionalen Oberflächenstruktur noch weitere Aufgaben erfüllen soll. Ein denkbares Anwendungsbeispiel hierfür ist das Aufbringen einer zusätzlichen Lage auf einem Flachleiter, welcher Kupfer oder eine Eisen-Nickel-Legierung, bzw. Alloy 42, aufweist, für eutektische Bauteile, bei dem dieser zusätzlichen Lage die Aufgabe eines mechanischen Puffers zukommt zur Kompensation von Spannungen, welche beim Aufbringen des Halbleiterchips entstehen.

Es ist ebenfalls denkbar und möglich, daß die verschiedenen Lagen entweder verschiedene chemische Zusammensetzungen aufweisen oder aber gleiche Zusammensetzung aufweisen, dann aber in verschiedenen Prozessen abgeschieden werden und so verschiedene mechanische Eigenschaften besitzen.

Nach dem Aufbringen der Zwischenschicht schließt sich als weiterer Prozeßschritt eine Behandlung der Oberfläche an, um die zur Verbesserung der Haftung benötigte dreidimensionale Struktur zu erhalten. Es wäre möglich, diese dreidimensionale Struktur durch gezielte Ausbildung von Dendriten an der Oberfläche zu bilden. Es ist aber aus wirtschaftlichen Gründen und auch wegen der Einfachheit der Prozeßkontrolle vorteilhaft, eine dreidimensionale Struktur durch Anätzen der Oberfläche der Zwischenschicht, also durch kontrolliertes Erzeugen von Lücken in der Oberfläche, zu bilden.

Es ist außerdem denkbar und möglich, daß diese dreidimensionale Struktur durch grobes Abscheiden bzw. von gröberen Bereichen oder Strukturen von Nickel und/oder Silber und/oder einer Silberlegierung mit anschließendem Anätzen erzeugt wird.

Zum Anätzen der Oberfläche bieten sich zwei verschiedene Ätzmethoden an, die je nach Zusammensetzung der Zwischenschicht unterschiedliche Vorteile haben können.

Zum einen besteht die Möglichkeit der Lückenerzeugung durch Korngrenzenätzung. Dieses Verfahren ist dann von Vorteil, wenn es sich bei der Zwischenschicht um eine reine Silberschicht handelt.

Falls die Zwischenschicht eine Silberverbindung und/oder Nickel und/oder eine Silberlegierung, wie zum Beispiel eine Silber-Zink-Legierung mit ca. 2% bis ca. 5% Zink, aufweist, ist es von Vorteil, zur Lückenbildung die Verbindungskomponente bzw. die Legierungskomponente durch Herausätzen zu entfernen.

Eine einfache Umsetzung des erfindungsgemäßen Verfahrens zur Herstellung eines Flachleiters mit erfindungsgemäßer Zwischenschicht, und deshalb vor allem aus wirtschaftlichen Gründen von Vorteil, sieht eine gleichmäßige Behandlung der gesamten Oberfläche des Flachleiterrahmens gemäß der vorliegenden Erfindung vor.

Je nach Art des Flachleiters und/oder des fertigen Bauteils kann es jedoch auch von Vorteil sein, nur bestimmte Bereiche des Flachleiters gemäß der vorliegenden Erfindung zu behandeln, also die dreidimensionale Oberflächenstruktur nur an bestimmten Stellen aufzubringen. Eine denkbare Anwendung sind Bauteile für den Bereich Fahrzeugtechnik, bei denen ein kritischer Punkt das Eindringen von Feuchtigkeit über kleinste Spalte zwischen Flachleiter und Kunststoff ist. Diese Spalte können reduziert werden durch das Aufbringen eines Rahmens mit haftungsverbessernder Oberflächenstruktur gemäß der vorliegenden Erfindung um den Halbleiterchip herum.

Die Art des Flachleiters und/oder des fertigen Bauteils bestimmt außerdem die chemische Zusammensetzung der Zwischenschicht. Je nach zum Beispiel geforderter elektrischer und thermischer Leitfähigkeit, Härte und/oder anderen gewünschten mechanischen Eigenschaften wird entweder eine reine Silberschicht und/oder eine Silberlegierung und/oder eine Silberverbindung und/oder Nickel von Vorteil sein.

Zur Verbesserung der Haftung von herkömmlicherweise verwendeten Kunststoffen auf der Oberfläche des Flachleiters ist es von Vorteil, wenn die Oberfläche der erfindungsgemäßen Zwischenschicht eine Geometrie wie im Folgenden beschrieben aufweist. Der typische Mittenrauwert Rₐ bzw. Welligkeit und/oder Flächenmittenrauwert Sₐ liegt zwischen ca. 0,1 µm und ca. 0,9 µm, vorzugsweise zwischen ca. 0,1 µm und ca. 0,5 µm. Die Matrix aus Inseln zurückbleibenden Materials weist typischerweise eine durchschnittliche Breite von ca. 0,5 µm und die sich darin befindlichen Lücken typischerweise eine Breite von ca. 2 µm auf.

Die Geometrie der Oberfläche der erfindungsgemäßen Zwischenschicht kann außerdem über das Verhältnis von Inseln zu Lücken beschrieben werden. Auswertung einer typischen Oberfläche gemäß der vorliegenden Erfindung ergibt das Folgende: Das Verhältnis der Flächen von Insel zu Lücke liegt typischerweise im Bereich zwischen ca. 2 : 1 bis ca. 1 : 2.

Weitere Ausführungsformen, auf die hier nicht näher eingegangen wird, beinhalten Zwischenschichten mit anderen Zusammensetzungen als den bisher erwähnten. Im Sinne der vorliegenden Erfindung geeignet sind alle Materialien, die gemäß der vorliegenden Erfindung an ihrer Oberfläche zur Erzeugung einer dreidimensionalen Struktur anätzbar sind. Vorteilhaft sind besonders diejenigen Materialien, die Zwischenschichten erzeugen, die für herkömmliche Chipbefestigungsverfahren und herkömmliche Kontaktierungsverfahren verwendbar sind.

Es ist außerdem denkbar und möglich, daß die erfindungsgemäße Zwischenschicht nicht mittels naßchemischer Methoden, sondern durch chemische oder physikalische Dampfabscheidverfahren, bzw. CVD (chemical vapor deposition) oder PVD (physical vapor deposition), aufgebracht wird. Eine derartige Ausführungsform ist dann von Vorteil, wenn an die resultierende Zwischenschicht extrem hohe Anforderungen bezüglich ihrer Reinheit gestellt wird.

Das erfindungsgemäße Halbleiterbauteil wird im Folgenden anhand von Ausführungsbeispielen entsprechend der Zeichnung beschrieben.
- Figur 1: zeigt einen Querschnitt durch ein erfindungsgemäßes Halbleiterbauteil,
- Figur 2: zeigt den schematischen Aufbau einer erfindungsgemäßen Zwischenschicht entsprechend einer ersten Ausführungsform,
- Figur 3: zeigt den schematischen Aufbau der erfindungsgemäßen Zwischenschicht aus Figur 2 nach der Durchführung eines Ätzprozesses,
- Figur 4: zeigt den schematischen Aufbau einer weiteren erfindungsgemäßen Zwischenschicht,
- Figur 5: zeigt den schematischen Aufbau der erfindungsgemäßen Zwischenschicht aus Figur 4 nach der Durchführung eines Ätzprozesses,
- Figur 6: zeigt den schematischen Aufbau einer erfindungsgemäßen Zwischenschicht entsprechend einer weiteren Ausführungsform,
- Figur 7: zeigt den schematischen Aufbau der erfindungsgemäßen Zwischenschicht aus Figur 6 nach der Durchführung eines Ätzprozesses,
- Figur 8: zeigt den schematischen Aufbau des Übergangs zwischen erfindungsgemäßen Zwischenschicht und Kunststoff entsprechend des ersten Ausführungsbeispiels,
- Figur 9: zeigt den schematischen Aufbau des Übergangs zwischen erfindungsgemäßen Zwischenschicht und Kunststoff entsprechend der Ausführungsbeispiele aus den Figuren 5 und 7 und
- Figur 10: zeigt eine Rasterelektronenmikroskop-Aufnahme der Oberfläche der erfindungsgemäßen Zwischenschicht nach der Durchführung des Ätzprozesses.

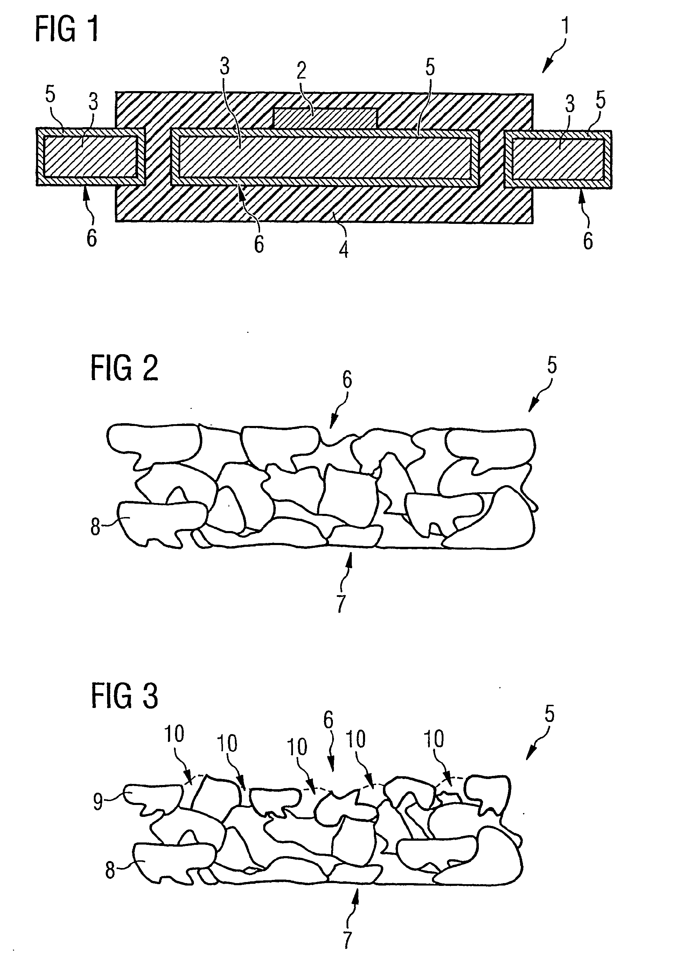

Figur 1 zeigt einen stark vergrößerten Querschnitt durch ein Halbleiterbauteil 1. Die Zeichnung ist nicht maßstabsgetreu, die Größenverhältnisse sind zur Verdeutlichung des schematischen Aufbaus verzerrt wiedergegeben.

Das Halbleiterbauteil 1 weist neben einem Halbleiterchip 2 einen Grundkörper 3 mit erfindungsgemäßer Zwischenschicht 5 auf. Halbleiterchip 2 und Grundkörper 3 sind von einer Kunststoffmasse 4 umgeben.

Die Kontaktierung des Halbleiterchips ist, zur Vereinfachung, und da sie für die vorliegende Erfindung nicht von Bedeutung ist, nicht dargestellt.

Figur 2 zeigt in starker Vergrößerung und nicht maßstabsgetreu den schematischen Aufbau der erfindungsgemäßen Zwischenschicht 5 vor der Durchführung des Ätzprozesses. Diese Zwischenschicht 5 weist entsprechend einer ersten Ausführungsform Silber auf. In der Figur sind die einzelnen Silberkörner 8 dargestellt, die eine geschlossen Oberfläche 6 ohne Lücken 10 bilden. Über die Unterseite 7 ist der Zwischenschicht 5 mit der Außenseite des Flachleiters (hier nicht gezeigt) verbunden.

Figur 3 zeigt in starker Vergrößerung und nicht maßstabsgetreu den schematischen Aufbau der erfindungsgemäßen Zwischenschicht 5 nach der Durchführung des Ätzprozesses. Wie bei Figur 1 weist diese Zwischenschicht 5 entsprechend einer ersten Ausführungsform Silber auf. Die Unterseite 7 der Zwischenschicht 5 ist identisch zu der in Figur 1 gezeigten. Die Oberfläche 6 weist jedoch jetzt Lücken 10 auf, die sich zwischen den kleineren, angeätzten Körnern 9 der Oberfläche 6 gebildet haben.

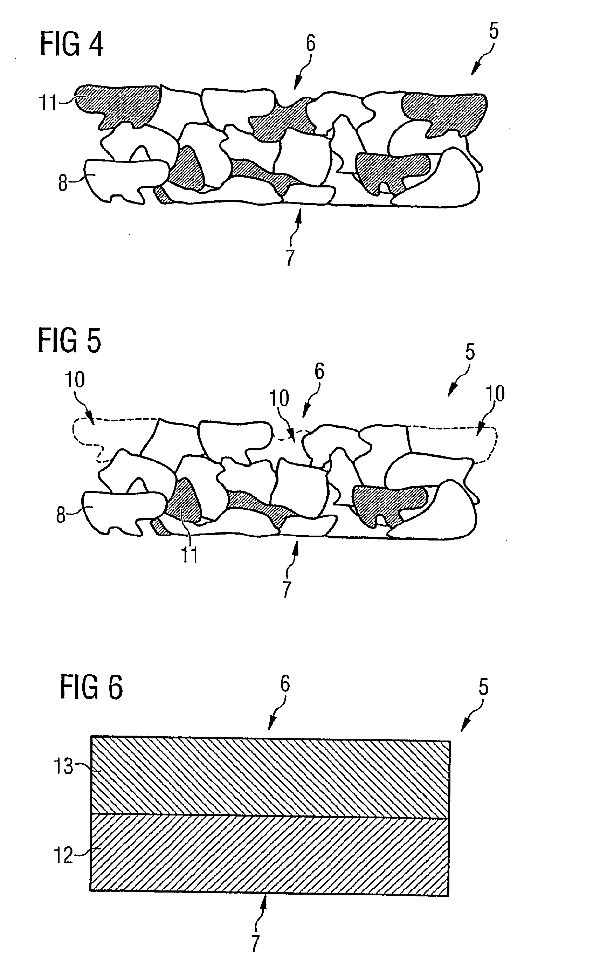

Figur 4 zeigt in starker Vergrößerung und nicht maßstabsgetreu den schematischen Aufbau der erfindungsgemäßen Zwischenschicht 5 gemäß einer alternativen Ausführungsform vor der Durchführung des Ätzprozesses. Diese Zwischenschicht 5 weist entsprechend dieser Ausführungsform eine Silberlegierung auf. Figur 4 zeigt deshalb neben den Silberkörnern 8 auch Körner 11, welche die weiteren Legierungskomponenten aufweisen. Die Zwischenschicht 5 weist ebenfalls eine Oberfläche 6 ohne Lücken 10 auf, die sich jedoch bei dieser Ausführungsform aus Silberkörnern 8 und aus Körnern der Legierungskomponente 11 zusammensetzt. Über die Unterseite 7 ist auch die Zwischenschicht 5 dieser Ausführungsform mit der Außenseite des Flachleiters (hier nicht gezeigt) verbunden.

Figur 5 zeigt in starker Vergrößerung und nicht maßstabsgetreu den schematischen Aufbau der erfindungsgemäßen Zwischenschicht 5 gemäß einer alternativen Ausführungsform nach der Durchführung des Ätzprozesses. Wie bei Figur 3 weist die Zwischenschicht 5 entsprechend dieser alternativen Ausführungsform eine Silberlegierung auf, d.h. es liegen neben den Silberkörnern 8 auch Körner der Legierungskomponente 11 vor. Die Unterseite 7 der Zwischenschicht 5 ist wiederum identisch zu der in Figur 3 gezeigten. Die Oberfläche 6 weist Lücken 10 auf, die sich im Unterschied zu Figur 2 durch Entfernen der Körner der Legierungskomponente 11 zwischen den zurückbleibenden Silberkörnern 8 gebildet haben. Die zurückbleibenden Silberkörner 8 sind in ihrer Größe unverändert.

Figur 6 zeigt in starker Vergrößerung und nicht maßstabsgetreu den schematischen Aufbau der erfindungsgemäßen Zwischenschicht 5 entsprechend einer weiteren Ausführungsform, wiederum vor der Durchführung des Ätzprozesses. Gemäß dieser Ausführungsform weist die Zwischenschicht 5 zwei Lagen unterschiedlicher Zusammensetzung auf, wobei im hier gezeigten Ausführungsbeispiel die untere Lage 12 Silber aufweist, während die obere Lage 13 aus einer Silberlegierung gebildet wird. Gemäß dieses Ausführungsbeispiels ist die Zwischenschicht 5 über die Unterseite 7 der unteren Lage 12 mit der Außenseite des Flachleiters (hier nicht gezeigt) verbunden. Der Aufbau der oberen Lage 13 dieser Zwischenschicht 5 entspricht dem in Figur 3 gezeigten Aufbau, mit dem Unterschied, daß die Unterseite der oberen Lage 13 nicht direkt mit dem Flachleiter in Kontakt steht, sondern die Schnittstelle zur unteren Lage 12 darstellt.

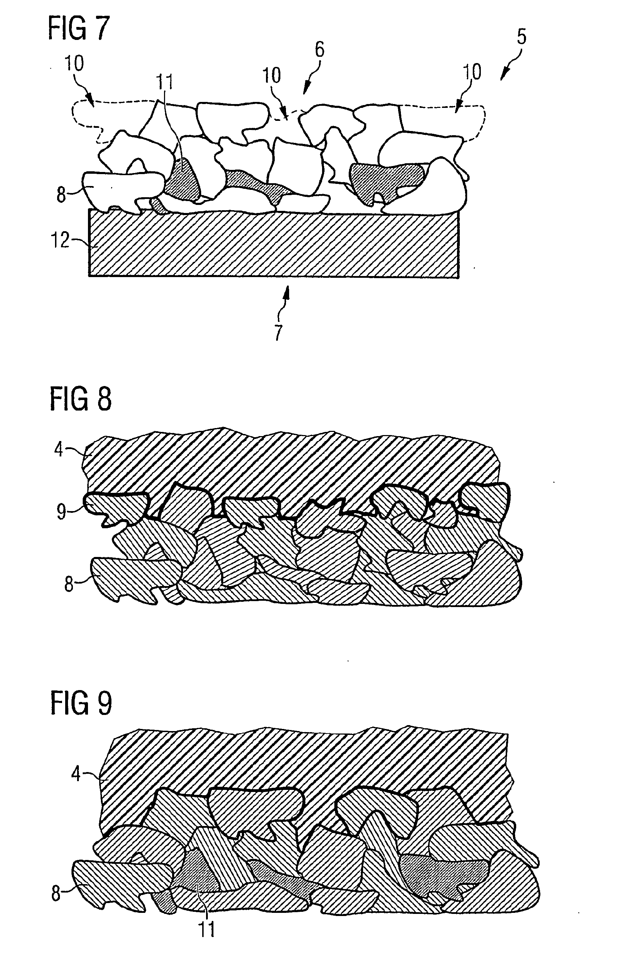

Figur 7 zeigt in starker Vergrößerung und nicht maßstabsgetreu den schematischen Aufbau der erfindungsgemäßen Zwischenschicht 5 entsprechend einer weiteren Ausführungsform, nach der Durchführung des Ätzprozesses. Die gebildete Oberflächenstruktur dieser Ausführungsform ist in ihrer Art vergleichbar mit der in Figur 5 gezeigten, d.h. sie enthält Lücken 10, die durch Herauslösen von Körnern der Legierungskomponente 11 unter Zurückbleiben der in ihrer Größe nicht veränderten Silberkörner 8 gebildet werden.

Figur 8 und Figur 9 zeigen in starker Vergrößerung und nicht maßstabsgetreu den schematischen Aufbau der erfindungsgemäßen Zwischenschicht 5 nach Durchführung des Ätzprozesses und nach Aufbringen des Kunststoffs 4 gemäß dem Halbleiterbauteil 1. Der Kunststoff 4 ist in die Lücken aus den Figuren 3, 5 und 7 eingedrungen.

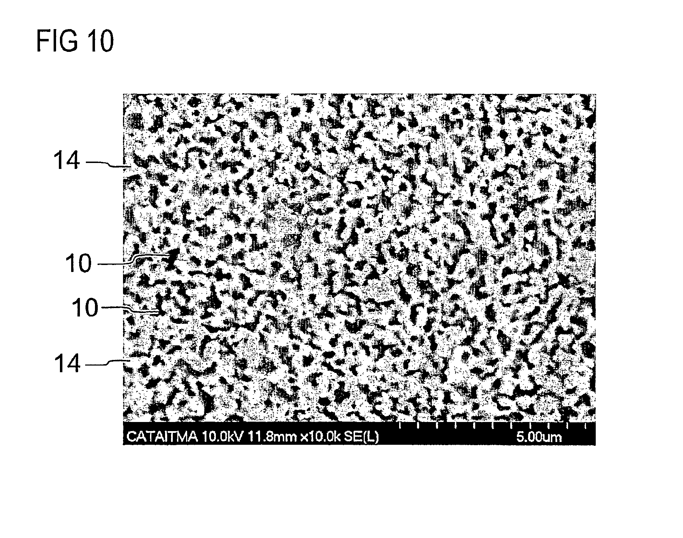

Figur 10 zeigt in der rasterelektronenmikroskopischen Aufnahme die dreidimensionale Struktur der Oberfläche 6 der Zwischenschicht 5 gemäß der ersten Ausführungsform. Zu erkennen sind als helle Bereiche die Inseln 14 des zurückbleibenden Materials mit einem typischen mittleren Durchmessern von ca. 0,5 µm, umgeben von dunklen Lücken 10 mit einer typischen mittleren Lückenbreite von ca. 2 µm.

Gemäß der vorliegenden Erfindung ist es allen Ausführungsformen gemein, daß durch den erfindungsgemäßen Ätzungsprozeß die Oberfläche 6 einer zu diesem Zweck auf den Grundkörper 3 aufgebrachten Zwischenschicht 5 so verändert wird, daß sich in der Oberfläche 6 der Zwischenschicht 5 Lücken 10 bilden, wie es in den Figuren 3, 5 und 7 schematisch gezeigt ist. Diese Lücken 10 ermöglichen dem Kunststoff 4 des Halbleiterbauteils 1 aufgrund ihrer Größe und Geometrie ein mechanisches Verankern auf oder Verzahnen mit der Oberfläche 6 der Zwischenschicht 5, wie in den Figuren 8 und 9 schematisch gezeigt ist.

Figur 6 und Figur 7 zeigen einen zweilagigen Aufbau der Zwischenschicht 5. Die obere Lage 13 der Zwischenschicht 5 wird erfindungsgemäß angeätzt, um die dreidimensionale Struktur zur Verankerung oder Verzahnung des Kunststoffs 4 auf der Zwischenschicht 5 zu erzeugen.

Die untere Lage 12 wird aufgebracht, um der Zwischenschicht 5 zusätzliche Eigenschaften, wie z.B. eine bestimmte Elastizität, zu verleihen. Obere Lage 13 und untere Lage 12 können, müssen aber nicht unterschiedliche chemische Zusammensetzungen aufweisen. Es ist denkbar und möglich, daß beide Lagen die gleiche chemische Zusammensetzung aufweisen, aber in verschiedenen Prozeßschritten abgeschieden werden und somit unterschiedliche mechanische Eigenschaften aufweisen.

In Figur 7 ist eine Ausführungsform mit einer oberen Lage 13 gezeigt, welche eine Silberlegierung aufweist. Die untere Lage 12 ist nicht näher spezifiziert, kann also z.B. Nickel und/oder Silber und/oder eine Silberlegierung aufweisen.

Die Rasterelektronenmikroskop-Aufnahme in Figur 10 zeigt die dreidimensionale Struktur der Oberfläche 6 der Zwischenschicht 5, die durch die Lücken 10 Räume für das Verankern oder Verzahnen des Kunststoffs 4 auf dieser Oberfläche 6 schafft.

Für die Erzeugung der erfindungsgemäßen Zwischenschicht entsprechend der Figur 3 wird wie im Folgenden beschrieben vorgegangen.

Für die Erzeugung der erfindungsgemäßen Zwischenschicht wurden die Korngrenzen der Silber aufweisenden Zwischenschicht 5, die auf einen vernickelten Flachleiterrahmen aufgebracht worden war, gemäß den in Tabelle 1 aufgelisteten Parametern mittels Schwefelsäure (H₂SO₄) angeätzt. Die Schwefelsäure wurde hierfür aus ca. 96%iger Schwefelsäure (H₂SO₄) durch Verdünnen mit Wasser entsprechend der in Tabelle 1 angegebenen Werte hergestellt.

**Tabelle 1 - Anätzen von Korngrenzen einer Silber-Zwischenschicht**

| Parameter | Wert ca. |
|---|---|
| Stromdichte | 2 A/dm² |
| Zeit | 16 sec |
| Temperatur | 55 °C |
| Verdünnung der ca. 96%igen Schwefelsäure mit Wasser | 140 ml/L |

Mittels dieser Ätzparameter wurde die in Figur 10 gezeigte dreidimensional Struktur auf der Oberfläche 6 der Silber aufweisenden Zwischenschicht 5 erzeugt, deren geometrische Kenngrößen in Tabelle 2 zusammengefaßt sind.

**Tabelle 2 - Typische geometrische Kenngrößen der angeätzten Oberfläche**

| Kenngröße | Wert ca. |
|---|---|
| Korngröße des Silbers (nach dem Anätzen) | ~ 0,5 µm |
| Breite der Lücken | ~ 2 µm |
| Mittenrauwert Rₐ bzw. Sₐ | 0,1 - 0,5 µm |

Der Mittenrauwert Rₐ ist definiert als das arithmetische Mittel der absoluten Profilabweichung innerhalb der Gesamtmeßstrecke, gleichbedeutend mit der Höhe eines Rechtecks, das flächengleich ist mit den Flächen zwischen Profilmittellinie und Istprofil.

Weitere Versuche wurden durchgeführt, um den gesamten Parameterraum zu bestimmen, innerhalb dessen das Anätzen der Silberkörner 8 zur Ausbildung der erfindungsgemäßen Zwischenschicht 5 führt, mit einer Oberflächengeometrie entsprechend der Kenngrößen in Tabelle 2. Das Ergebnis dieser Versuche ist in Tabelle 3 zusammengefaßt.

**Tabelle 3 - Bereich der möglichen Ätzparameter**

| Parameter | Wert ca. |
|---|---|
| Stromdichte | 0,5 - 4 A/dm² |
| Zeit | 4 - 40 sec |
| Temperatur | 25 - 60 °C |
| Verdünnung der ca. 96%igen Schwefelsäure mit Wasser | 100 - 200 ml/L |

Ein weiteres Ergebnis dieser Versuche gemäß der vorliegenden Erfindung war außerdem Bereich der möglichen Mittenrauwerte, also diejenigen Mittenrauwerte, für die das gewünschte Verzahnen oder Verankern des Kunststoffs 4 an der Oberfläche 6 der Zwischenschicht 5 möglich ist. Nach diesen Versuchen liegen die Mittenrauwerte Rₐ typischerweise zwischen 0,1 und 0,9 µm.

Gemäß der vorliegenden Erfindung kann entsprechend dem hier gezeigten Beispiel ein Parameterraum für das Herausätzen der Legierungskomponenten in der Zwischenschicht 5, welche Nickel und/oder eine Silberlegierung und/oder eine Silberverbindung aufweist, gefunden werden.

## Patentansprüche

1. Verfahren zum Herstellen eines zur Bestückung mit einem Halbleiterchip (2) und zur Umhüllung mit einer Kunststoffmasse (4) vorgesehenen Flachleiterrahmens, das die folgenden Schritte aufweist:
- Bereitstellen eines Flachleiterrahmens,
- Aufbringen einer durch ein Ätzmittel angreifbaren Zwischenschicht (5) aus Silber, einer Silberlegierung und/oder einer Silberverbindung und/oder Nickel, welche eine oder mehrere Lagen aufweist, auf den Flachleiterrahmen,
- teilweises oder vollständiges Anätzen der Oberfläche (6) der Zwischenschicht (5) mit dem Ätzmittel.

2. Verfahren nach Anspruch 1,
**dadurch gekennzeichnet, daß**
die Zwischenschicht (5) mittels chemischer oder galvanischer Verfahren abgeschieden wird.

3. Verfahren nach Anspruch 1,
**dadurch gekennzeichnet, daß**
die Zwischenschicht (5) als grobe Abscheidung aufgebracht wird.

4. Verfahren nach einem der vorhergehenden Ansprüche,
**dadurch gekennzeichnet, daß**
die Zwischenschicht (5) als eine oder mehrere Lagen mit jeweils einheitlicher Zusammensetzung aufgebracht wird.

5. Verfahren nach einem der vorhergehenden Ansprüche,
**dadurch gekennzeichnet, daß**
das Anätzen als Korngrenzenätzen an der Oberfläche (6) der Zwischenschicht (5) und/oder durch selektives Herausätzen zumindest eines der Legierungsbestandteile oder Verbindungskomponenten des Silbers an der Oberfläche (6) der Zwischenschicht (5) erfolgt.

6. Verfahren nach einem der vorhergehenden Ansprüche,
**dadurch gekennzeichnet, daß**
sowohl das Aufbringen der Zwischenschicht (5) als auch die Ätzung ganzflächig, bzw. auf der gesamten Oberfläche des Flachleiterrahmens ausgeführt wird.

7. Verfahren nach einem der vorhergehenden Ansprüche,
**dadurch gekennzeichnet, daß**
sowohl das Aufbringen der Zwischenschicht als auch die Ätzung selektiv an bestimmten Stellen der Oberfläche des Flachleiterrahmens ausgeführt wird.

8. Verfahren zum Herstellen eines Halbleiterbauteils (1), das die folgenden Schritte aufweist:
- Bereitstellen eines Flachleiterrahmens, hergestellt nach einem der vorhergehenden Ansprüche,
- Aufsetzen eines Halbleiterchips (2) auf den Flachleiterrahmen,
- Aufbringen einer Kunststoffmasse (4) als umhüllendes Gehäuse auf Flachleiterrahmen und Halbleiterchip (2).

9. Flachleiterrahmen, der zur Bestückung mit einem Halbleiterchip (2) und zur Umhüllung mit einer Kunststoffmasse (4) vorgesehen ist, wobei der Flachleiterrahmen die folgenden Merkmale aufweist:
- einen metallischen einstückigen Grundkörper (3) eines Flachleiterrahmens,
- wenigstens eine auf dem Grundkörper (3) aufgebrachte Zwischenschicht (5) aus Silber, einer Silberlegierung und/oder einer Silberverbindung und/oder Nickel, welche eine oder mehrere Lagen aufweisen kann,
wobei die Zwischenschicht (5) eine Oberfläche (6) mit einer Matrix aus Inseln (14) zurückbleibenden Materials von im wesentlichen einheitlicher Höhe und sich dazwischen erstreckender Lücken (10) aufweist.

10. Flachleiterrahmen nach Anspruch 9,
**dadurch gekennzeichnet, daß**
die Oberfläche (6) der Zwischenschicht (5) typischerweise einen Mittenrauwert Ra zwischen ca. 0,1 µm und ca. 0,9 µm, vorzugsweise zwischen ca. 0,1 µm und ca. 0,5 µm aufweist.

11. Flachleiterrahmen nach einem der Ansprüche 9 oder 10,
**dadurch gekennzeichnet, daß**
die verbleibenden Inseln (14) an der Oberfläche (6) der Zwischenschicht (5) typischerweise einen mittleren Durchmesser von ca. 0,5 µm aufweisen.

12. Flachleiterrahmen nach einem der Ansprüche 9 bis 11,
**dadurch gekennzeichnet, daß**
die Lücken (10) an der Oberfläche (6) der Zwischenschicht (5) typischerweise eine mittlere Breite von ca. 2 µm aufweisen.

13. Flachleiterrahmen nach einem der Ansprüche 9 bis 12,
**dadurch gekennzeichnet, daß**
die Oberfläche (6) der Zwischenschicht (5) typischerweise ein Verhältnis der Flächen von Inseln (14) zu Lücken (10) im Bereich von ca. 2 : 1 bis ca. 1 : 2 aufweist.

14. Halbleiterbauteil mit einem Flachleiterrahmen (3) nach einem der Ansprüche 9 bis 13, mit einem Halbleiterchip (2) und mit einer Umhüllung aus Kunststoffmasse (4).

## Claims

1. Process for producing a leadframe which is intended to be fitted with a semiconductor chip (2) and to be encapsulated with a plastic compound (4), which process includes the following steps:
- providing a leadframe,
- applying an interlayer (5), which can be attacked by an etchant, being composed of silver, a silver alloy and/or a silver compound and/or nickel and including one or more individual layers, on the leadframe,
- partially or completely etching into the surface (6) of the interlayer (5) using the etchant.

2. Process according to claim 1, **characterized in that** the interlayer (5) is deposited by means of chemical or electrodeposition processes.

3. Process according to claim 1, **characterized in that** the interlayer (5) is applied as a coarse deposit.

4. Process according to one of the preceding claims, **characterized in that** the interlayer (5) is applied in the form of one or more individual layers each having a uniform composition.

5. Process according to one of the preceding claims, **characterized in that** the etching is effected as grain boundary etching at the surface (6) of the interlayer (5) and/or is carried out by selectively etching out at least one of the alloying constituents or the compound components of the silver at the surface (6) of the interlayer (5).

6. Process according to one of the preceding claims, **characterized in that** the application of the interlayer (5) and the etching are both carried out over the entire surface of the leadframe.

7. Process according to one of the preceding claims, **characterized in that** both the application of the interlayer and the etching are carried out selectively at defined locations of the surface of the leadframe.

8. Process for producing a semiconductor device (1), which includes the following steps:
- providing a leadframe as described in one of the preceding claims,
- placing a semiconductor chip (2) onto the leadframe,
- applying a plastic compound (4) as encapsulating housing to leadframe and semiconductor chip (2).

9. Leadframe which is intended to be fitted with a semiconductor chip (2) and to be encapsulated with a plastic compound (4), the leadframe having the following features:
- a metallic single-piece base body (3) of a leadframe,
- at least one interlayer (5) which has been applied to the base body (3), is composed of silver, a silver alloy and/or a silver compound and/or nickel and may comprise one or more individual layers,
the interlayer (5) having a surface (6) comprising a matrix of islands (14) of remaining material of substantially uniform height with voids (10) extending between these islands.

10. Leadframe according to claim 9, **characterized in that** the surface (6) of the interlayer (5) typically has a roughness average Ra of between approx. 0.1 µm and approx. 0.9 µm, preferably between approx. 0.1 µm and approx. 0.5 µm.

11. Leadframe according to one of claims 9 to 10, **characterized in that** the remaining islands (14) at the surface (6) of the interlayer (5) typically have a mean diameter of approx. 0.5 µm.

12. Leadframe according to one of claims 9 to 11, **characterized in that** the voids (10) at the surface (6) of the interlayer (5) typically have a mean width of approx. 2 µm.

13. Leadframe according to one of claims 9 to 12, **characterized in that** the surface (6) of the interlayer (5) typically has a ratio of the surface areas of islands (14) to voids (10) in the range from approx. 2:1 to approx. 1:2.

14. Semiconductor device having the leadframe (3) as claimed in one of claims 9 to 13, having a semiconductor chip (2) and having an encapsulation of plastic compound (4).

## Revendications

1. Procédé pour la préparation d'un cadre de conducteur plat prévu pour être équipé d'une puce de semi-conducteur (2) et pour l'enrobage au moyen d'une masse de plastique (4), qui présente les étapes suivantes :
- mise à disposition d'un cadre de conducteur plat,
- application d'une couche intermédiaire (5) d'argent, d'alliage d'argent et/ou d'un composé d'argent et/ou de nickel susceptible d'une attaque par des agents de gravure, qui présente une ou plusieurs strates, sur le cadre de conducteur plat,
- gravure partielle ou totale de la surface (6) de la couche intermédiaire (5) au moyen de l'agent de gravure.

2. Procédé selon la revendication 1, **caractérisé en ce que** la couche intermédiaire (5) est séparée par un procédé chimique ou galvanique.

3. Procédé selon la revendication 1, **caractérisé en ce que** la couche intermédiaire (5) est appliquée comme séparation grossière.

4. Procédé selon l'une des revendications qui précèdent,
**caractérisé en ce que** la couche intermédiaire (5) est appliquée sous la forme d'une ou de plusieurs strates dont la composition est uniforme dans tous les cas.

5. Procédé selon l'une des revendications qui précèdent,
**caractérisé en ce que** la gravure a lieu en tant que gravure des limites de grains à la surface (6) de la couche intermédiaire (5) et/ou par gravure d'élimination sélective d'au moins l'un des composants de l'alliage ou des composantes de liaison de l'argent à la surface (6) de la couche intermédiaire (5).

6. Procédé selon l'une des revendications qui précèdent,
**caractérisé en ce que** tant l'application de la couche intermédiaire (5) que la gravure sont exécutées à grande surface, respectivement sur la totalité de la surface du cadre de conducteur plat.

7. Procédé selon l'une des revendications qui précèdent,
**caractérisé en ce que** tant l'application de la couche intermédiaire que la gravure sont exécutées sélectivement en certains points de la surface du cadre de conducteur plat.

8. Procédé pour la préparation d'un composant semi-conducteur (1) qui présente les étapes suivantes :
- mise à disposition d'un cadre de conducteur plat, préparé selon l'une des revendications qui précèdent,
- pose d'une puce de semi-conducteur (2) sur le cadre de conducteur plat,
- application d'une masse de plastique (4) comme enveloppe sur le cadre de conducteur plat et la puce de semi-conducteur (2).

9. Cadre de semi-conducteur qui est prévu pour être équipé d'une puce de semi-conducteur (2) et pour un enrobage au moyen d'une masse de plastique (4), le cadre de semi-conducteur présentant les caractéristiques suivantes .
- un corps de base (3) métallique d'une seule pièce d'un cadre de conducteur plat,
- au moins une couche intermédiaire (5) en argent, en alliage d'argent et/ou en composé d'argent et/ou de nickel sur le corps de base (3), ladite couche pouvant présenter une ou plusieurs strates, la couche intermédiaire (5) présente une surface (6) avec une matrice constituée d'îlots (14) de matériau résiduel à la hauteur essentiellement uniforme et de lacunes (10) qui s'étendent entre lesdits îlots.

10. Cadre de semi-conducteur selon la revendication 9, **caractérisé en ce que** la surface (6) de la couche intermédiaire (5) présente typiquement un valeur de rugosité moyenne Rₐ comprise entre environ 0,1 µm et environ 0,9 µm, préférentiellement entre environ 0,1 µm et environ 0,5 µm.

11. Cadre de semi-conducteur selon l'une des revendications 9 ou 10, **caractérisé en ce que** les îlots résiduels (14) à la surface (6) de la couche intermédiaire (5) présentent typiquement un diamètre moyen d'environ 0,5 µm.

12. Cadre de semi-conducteur selon l'une des revendications 9 à 11, **caractérisé en ce que** les lacunes (10) à la surface (6) de la couche intermédiaire (5) présentent typiquement une largeur moyenne d'environ 2 µm.

13. Cadre de semi-conducteur selon l'une des revendications 9 à 12, **caractérisé en ce que** la surface (6) de la couche intermédiaire (5) présente typiquement un rapport des surfaces des îlots (14) aux lacunes (10) compris entre environ 2 : 1 et environ 1 : 2.

14. Composant semi-conducteur avec un cadre de semi-conducteur (3) selon l'une des revendications 9 à 13, avec une puce de semi-conducteur (2) et un enrobage constitué d'une masse de plastique (4).
